# EUROPÄISCHE PATENTSCHRIFT

(11) **EP 0 458 053 B1**
(45) Veröffentlichungstag und Bekanntmachung des Hinweises auf die Patenterteilung: **05.10.1994**
(21) Anmeldenummer: 91105846.9
(22) Anmeldetag: 12.04.1991
(51) Int. Cl.: G01M 15/00

(54) **Fahrbares Kraftfahrzeugprüfgerät**
Rolling device for testing vehicles
Dispositif roulant pour l'examen des véhicules

(30) Priorität: 25.05.1990 DE 4016817
(43) Veröffentlichungstag der Anmeldung: 27.11.1991
(73) Patentinhaber: ROBERT BOSCH GMBH, 70442 Stuttgart (DE)
(72) Erfinder: Grötzner, Kurt, W-7000 Stuttgart 40 (DE); Schmidt, Roland, W-7300 Esslingen (DE); Schneider, Richard, W-7901 Weidenstetten (DE); Frohnwieser, Bernhard, W-7321 Wangen b. Göppingen (DE); Kleger, Bruno, W-7341 Amstetten (DE)

(56) Entgegenhaltungen:
- EP-A- 0 090 756
- DE-A- 2 243 398
- US-A- 4 113 980

## Beschreibung

### Stand der Technik

Die Erfindung geht aus von einem fahrbaren Kraftfahrzeugprüfgerät gemäss den Oberbegriff des unabhängigen Patentanspruchs.

Es ist schon ein solches fahrbares Kraftfahrzeugprüfgerät bekannt (DE-A-28 41 296, EP-A-0 081 353 ), bei dem das auf einem Gestell mit Rollen angeordnete Testsystem einen Kabelausleger aufweist, an dessen freiem Ende mehrere flexible Kabel angeordnet sind. Die Enden der Kabel sind mit Anschlüssen versehen, die als Sensoren und Meßleitungen ausgebildet sind, wobei für derartige Testsysteme Stromzangen, OT-Geber, kapazitive Meßwertgeber, Zündlichtstroboskope, etc. notwendig sind. Um die vom Kabelausleger herabhängenden Kabel vor einem gegenseitigen Verwickeln zu schützen, ist am freien Ende des Kabelauslegers eine Aufhängevorrichtung vorgesehen, an welcher die Anschlüsse griffbereit aufgehängt werden können. Das andere Ende des Kabelauslegers ist am Gestell des Testsystems drehbar gelagert, damit die Anschlüsse bequem zu einem Motorraum geschwenkt werden können, wenn das zu überprüfende Kraftfahrzeug an das Testsystem angeschlossen werden soll. Aufgrund immer komplexer werdender Motorsysteme werden auch die Anforderungen an das Kraftfahrzeugprüfgerät zunehmend größer. Dies äußert sich einerseits darin, daß sich die Anzahl der erforderlichen Sensoren bzw. Anschlüsse erhöht oder daß andererseits neue Testfunktionen gefordert werden, wie dies zum Beispiel für verteilerlose Zündsysteme bei der Prüfung der sogenannten ruhenden Hochspannungsverteilung gefordert wird. Eine Nachrüstung kann daher in solchen Fällen häufig schwer durchführbar sein. Ferner kann es von Nachteil sein, wenn die flexiblen Kabel von den einzelnen Anschlüssen über den Kabelausleger hinweg bis in die Prüfgeräte des Testsystems geführt werden müssen und somit lang bauen. Dies führt zu langen Signalübertragungsstrecken und zudem zu hohen Kosten beim Auswechseln eines teuren, beschädigten Kabels. Außerdem erschweren lange Kabel die Bedienbarkeit, da sie sich leicht verwickeln können. Ferner führt die Aufhängevorrichtung für die Anschlüsse am Ende des Kabelauslegers dazu, daß eine Bedienungsperson beim An- und Abklemmen der Anschlüsse relativ lange Strecken überwinden muß und damit zeitraubend arbeitet. Auch kann es vorkommen, daß bei solchen Kraftfahrzeugprüfgeräten die Lage von Anzeige- und Bedienungselementen im fahrbaren Testsystem in ungünstigen Fällen zu weit abliegt und schlecht einsehbar ist.

### Vorteile der Erfindung

Das erfindungsgemäße fahrbare Kraftfahrzeugprüfgerät mit den kennzeichnenden Merkmalen des unabhängigen Patentanspruchs 1 hat demgegenüber den Vorteil, daß sich die Anforderungen hinsichtlich Nachrüstbarkeit und Bedienbarkeit an solche Kraftfahrzeugprüfgeräte wesentlich leichter und zweckmäßiger erfüllen lassen. So lassen sich zusätzliche Funktionen ohne weiteres nachträglich in dem separaten Gerät unterbringen, das am freien Ende des Kabelauslegers aufgehängt bzw. befestigt ist. Durch die Ausbildung der Aufhängevorrichtung an diesem Gerät können die einzelnen Anschlüsse in besonders günstiger Weise am Gerät aufbewahrt, griffgünstig entnommen und dort auch wieder abgelegt werden. Durch eine solche motornahe Anordnung der Anschlüsse bzw. Sensoren werden die Greifwege für die Bedienungspersonen kürzer und somit die Rüstzeiten beim An- und Abklemmen der Anschlüsse kürzer. Auch die Länge der Kabel kann wesentlich kürzer gehalten werden, woraus sich Vorteile bezügl. deren Kosten, deren Handhabung und der elektrischen Einstreuung ergeben. Dabei läßt sich das Gerät besonders vorteilhaft gestalten, wenn die flexiblen Kabel mit ihren von den Anschlüssen abgewandten Enden mit Hilfe von Steckanschlüssen an der Unterseite des Gerätes befestigt sind. Insgesamt läßt sich dadurch bei hoher Flexibilität eine platzsparende und kostengünstige Nachrüstung durchführen.

Durch die in den abhängigen Patentansprüchen aufgeführten Maßnahmen sind vorteilhafte Weiterbildungen und Verbesserungen des im unabhängigen Patentanspruch angegebenen Kraftfahrzeugprüfgerätes möglich. Besonders günstig ist eine Ausbildung nach Anspruch 2, wenn im Gerät die Sensorelektronik angeordnet wird.

Im Inneren des Gerätes können damit bereits elektrische Schaltungen und Funktionen zusätzlich untergebracht werden. Dadurch begünstigt wird die Möglichkeit einer Doppelbelegung von Steckplätzen an der Unterseite des Gerätes, so daß die Anzahl der Steckanschlüsse auf ein Minimum reduziert werden kann. Ferner ergeben sich dadurch zum Zweck der Leitungsreduzierung und zur Erhöhung der Störsicherheit zwischen Testsystem und den verschiedenen Anschlüssen vielfältige Möglichkeiten zur Signalaufbereitung und Signalweiterleitung. Zweckmäßig ist es, wenn gemäß den Ansprüchen 3 und 4 unmittelbar am Gerät eine Anzeigevorrichtung und eine Bedieneinrichtung angeordnet wird, was die Arbeitsweise der das Kraftfahrzeug überprüfenden Bedienungsperson erheblich erleichtert. Es ist damit möglich, komplette Testerfunktionen nahe an dem zu prüfenden Motor zu plazieren. Im Zuge der Miniaturisierung von elektronischen Bauelementen wird dies besonders begünstigt. Die Bedienung des Geräts und die Anzeige von Meßergebnissen erfolgen dann aus nächster Nähe, sozusagen im Griffbereich und im Blickfeld des Kfz-Mechanikers. Äußerst günstig ist es dabei, wenn gemäß Anspruch 5 das am Kabelausleger aufgehängte Gerät nicht nur in einer horizontalen Ebene, sondern auch vertikal verstellbar ist. Damit kann die Positionierung des Kabelauslegers und damit der Anschlüsse bzw. Sensoren noch universeller gestaltet werden, was gerade z.B. bei Kombi-Fahrzeugen mit im Fahrerhaus liegendem Motor von Vorteil ist. Für eine gute Vorstellbarkeit und leichte Handhabung ist es dabei günstig, wenn gemäß Anspruch 6 eine Gewichtsentlastungseinrichtung vorgesehen wird. Aus den Ansprüchen 7 bis 9 ergeben sich zweckmäßige Ausgestaltungen eines Kraftfahrzeugprüfgerätes mit höhenverstellbarem Gerät. Ferner ist eine Ausbildung nach Anspruch 10 besonders günstig, wodurch neben den elektrischen Größen auch fluidische Größen überwacht und geprüft werden können. Ferner ist es zweckmäßig, wenn gemäß Anspruch 11 die Signalübertragung vom Gerät zum eigentlichen Testsystem in kostengünstigerer und weniger störanfälliger Weise durchgeführt wird. Weiterhin ist es günstig, wenn für die Bedienungsperson auf der Oberseite des Gerätes gemäß Anspruch 12 Ablagemöglichkeiten geschaffen werden, um somit durch griffbereite Ablage für Werkzeuge, Kleinteile etc. die Bedienung und Handhabung zu erleichtern.

### Zeichnung

Vier Ausführungsbeispiele der Erfindung sind in den Zeichnungen dargestellt und in der nachfolgenden Beschreibung näher erläutert. Es zeigen Fig. 1 ein fahrbares Kraftfahrzeugprüfgerät in einer stark vereinfachten Ausführungsform, Fig. 2 und Fig. 3 eine zweite bzw. dritte Ausführungsform des Kraftfahrzeugprüfgeräts ebenfalls in vereinfachter Darstellung und Fig. 4 einen Teil eines vierten Kraftfahrzeugprüfgerätes in vergrößertem Maßstab.

### Beschreibung der Ausführungsbeispiele

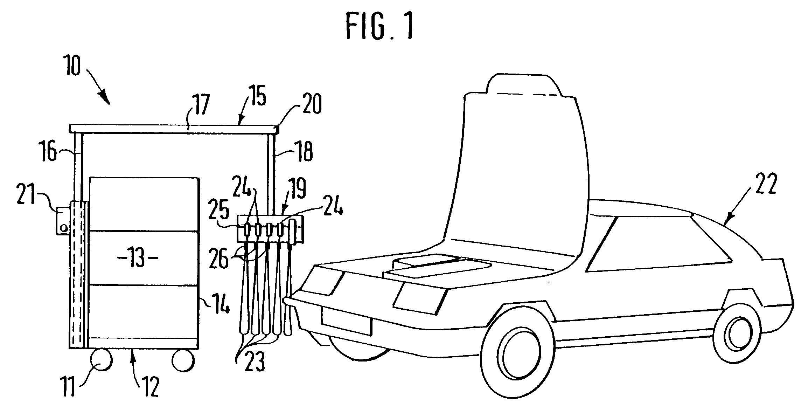

Die Fig. 1 zeigt ein fahrbares Kraftfahrzeugprüfgerät 10 in vereinfachter Darstellung. Das Kraftfahrzeugprüfgerät weist ein mit Rollen 11 versehenes Gestell 12 auf, auf dem ein aus verschiedenen Meß- und Prüfeinrichtungen bestehendes Testsystem 13 angeordnet ist. An einem Gehäuse 14 des Testsystems 13 ist ein Kabelausleger 15 schwenkbar befestigt. Der Kabelausleger 15 besteht im wesentlichen aus einer Schwenkachse 16, einem daran befestigten, auskragendem Ausleger 17 und einem am auskragenden Ende 20 des Auslegers 17 befestigten Arm 18, an welchem ein Gerät 19 hängt. Die Schwenkachse 16 ist mit Hilfe einer Verstelleinrichtung 21 zusätzlich der Höhe nach verstellbar und in ihrer jeweiligen Höhenlage feststellbar. Auf diese Weise kann das Gerät 19 nicht nur in der horizontalen Ebene verschwenkt, sondern auch in seiner Höhenlage in begrenztem Umfang verstellt werden. Dabei ist der Kabelausleger 17 so ausgebildet, daß das Gerät 19 im Betrieb etwa in Motorraumhöhe des zu prüfenden Fahrzeugs 22 gehalten wird.

An dem Gerät 19 sind mehrere, flexible Kabel 23 angeordnet, die an ihrem einen, freien Ende jeweils einen Anschluß 24 aufweisen, um die erforderlichen Sensoren und Meßleitungen wie z.B. Stromzangen, OT-Geber, kapazitive Meßwertgeber, Zündlichtstroboskope etc. an die geeigneten Prüf- und Meßpunkte im Fahrzeug 22 anzuschließen. Diese Anschlüsse 24 sind in einer Aufhängevorrichtung 25 an der Frontseite des Gerätes 19 griffgünstig aufbewahrt. Die flexiblen Kabel 23 weisen an ihren anderen Enden geeignete Steckanschlüsse 26 auf, mit denen sie am Boden des Geräts 19 lösbar befestigt sind. Das Gerät 19 ist so ausgebildet, daß es in seinem Inneren elektrische Schaltungen für verschiedene Funktionen aufnehmen kann, insbesondere die Sensorelektronik. Es kann daher bereits im Gerät 19 eine Signalaufbereitung vor Ort stattfinden, so daß die Weiterleitung der Signale zum eigentlichen Testsystem 13 über den Kabelausleger 15 in vielfacher Weise gestaltet werden kann. Besonders günstig ist es, wenn diese Weiterleitung der Signal durch eine Opto-Kopplung oder in Lichtleittechnik geschieht, so daß keine störenden elektrischen Einstreuungen möglich sind.

Die Wirkungsweise des Kraftfahrzeugprüfgeräts 10 bezügl. seiner einzelnen Meß- und Prüffunktionen ist an sich bekannt und braucht im vorliegenden Zusammenhang nicht näher erläutert zu werden. Das fahrbare Kraftfahrzeugprüfgerät 10 läßt sich leicht an den zu prüfenden Pkw 22 heranfahren, wobei durch Schwenken des Kabelauslegers 17 das Gerät 19 möglichst nahe und günstig zum Prüfling plaziert werden kann, so daß die Anschlüsse 24 aus ihrer Aufhängevorrichtung 25, wo sie in der Ruhestellung aufbewahrt werden, griffgünstig entnommen werden können und im zu überprüfenden Fahrzeug angeschlossen werden können. Dabei können in dem Gerät 19 sehr einfach zusätzliche Funktionen nachgerüstet werden, so daß beispielsweise für verteilerlose Zündsysteme eine sogenannte ruhende Hochspannungsverteilung geprüft werden kann. Durch die motornahe Anordnung der Anschlüsse 24 am Gerät 19 werden die Greifwege für den Kfz-Mechaniker relativ kurz und somit sind auch die Rüstzeiten beim An- und Abklemmen der Sensoren günstig. Zudem kann die Länge der Kabel 23 durch die günstige Raumlage des Geräts 19 erheblich kürzer gehalten werden im Vergleich zu früheren Geräten, wodurch sich Vorteile bezüglich der Kosten und der Handhabung ergeben zumal flexible Kabel leicht zum Verwickeln neigen. Die relativ kurz bauenden Kabel 23 können infolge ihrer Steckanschlüsse 26 leicht ausgewechselt werden. Dabei ist es durch die in dem Gerät 19 angeordnete Sensorelektronik möglich, einzelne Steckplätze doppelt zu belegen, so daß die Anzahl der Steckanschlüsse auf ein Minimum reduziert werden kann.

Das Kraftfahrzeugprüfgerät 10 ist dabei sehr universell einsetzbar, da der Kabelausleger 15 in seiner Höhe selbst verstellbar ist. Dies kann besonders bei Kombi-Fahrzeugen mit im Fahrerhaus liegendem Motor von Vorteil sein, wo das Gerät 19 in eine gute Ausgangslage gebracht werden kann. Ferner sollen aus Gründen der einfacheren Handhabung die Anschlüsse 24 bzw. deren Sensoren über eine geöffnete Motorhaube geschwenkt werden können. Dies ist vor allem dann erforderlich, wenn die Motorhaube nicht zur Windschutzscheibe hin geöffnet wird, sondern wie bei einigen marktgängigen Modellen um eine vorne liegende Achse geschwenkt wird. Für eine Bedienungsperson ist es zuweilen erst nach dem Öffnen der Motorhaube erkennbar, ob die günstigste Anschlußmöglichkeit z.B. von rechts oder von links erfolgen kann. Um nun zu verhindern, daß die Motorhaube noch einmal geschlossen werden muß oder das ganze Testsystem einen Ortswechsel erfahren muß, ist diese vertikale Bewegungsmöglichkeit des Geräts 19 von besonderem Vorteil. Dabei ist beim Kraftfahrzeugprüfgerät 10 durch die Verstelleinrichtung 21, die in die Lagerung der Schwenkachse 16 integriert ist, eine Höheneinstellung möglich, wobei dann diese Höhelage eingehalten wird.

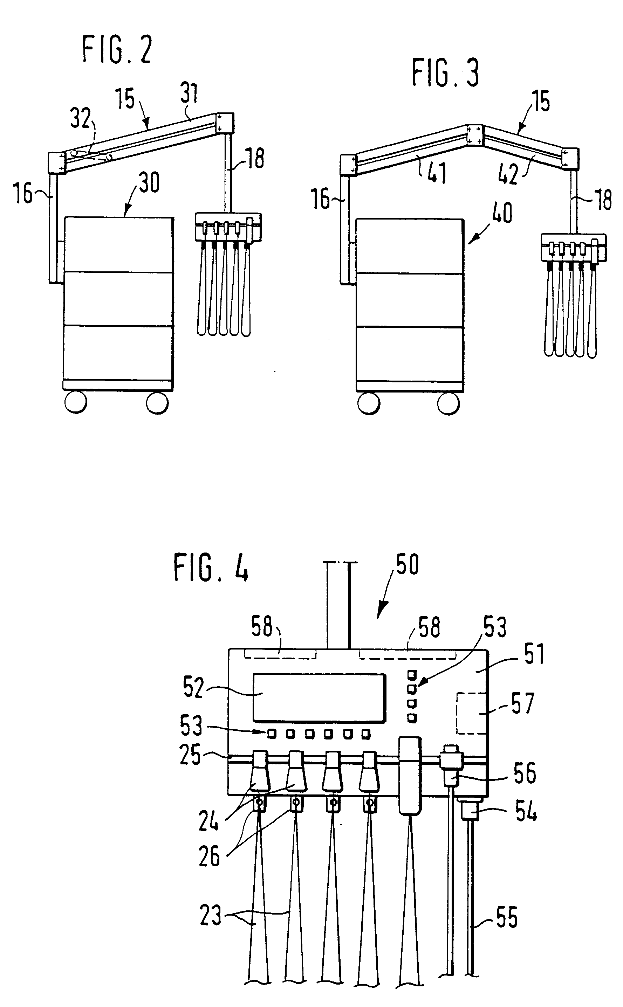

Die Fig. 2 zeigt ein zweites Kraftfahrzeugprüfgerät 30, das sich von demjenigen nach Fig. 1 wie folgt unterscheidet, wobei für gleiche Bauelemente gleiche Bezugszeichen verwendet werden: Das zweite Kraftfahrzeugprüfgerät 30 hat einen Kabelausleger 15, bei dem anstelle des festen Auslegers 17 nach Fig. 1 zwischen der Schwenkachse 16 und dem Arm 18 ein als Parallelogramm ausgebildeter Tragarm 31 vorgesehen ist, mit dessen Hilfe die Höhenverstellung durchführbar ist.

Zur Gewichtsentlastung von Kabelausleger 15 und Gerät 19 ist dabei zwischen den beiden Streben des Tragarms 31 eine Gasdruckfeder 32 angeordnet. Zur Feststellung der Höhenlage des Tragarms 21 kann eine nicht näher bezeichnete Klemmvorrichtung verwendet werden. Somit läßt sich auch beim zweiten Kraftfahrzeugprüfgerät 30 eine vertikale Verstellung der Anschlüsse 24 durchführen, wobei diese unabhängig von der Höhenverstellung in einer horizontalen Lage verbleiben. Das Gerät 19 und somit die Anschlüsse 24 lassen sich in einer beliebigen Motorraumhöhe positionieren, so daß unterschiedliche Kraftfahrzeuge wie PKW, Geländewagen, Kombi geprüft werden können wobei die Kabel 23 relativ kurz bauen.

Die Fig. 3 zeigt ein drittes Kraftfahrzeugprüfgerät 40, das sich von demjenigen nach Fig. 2 lediglich dadurch unterscheidet, daß im Kabelausleger 15 zwischen Schwenkachse 16 und Arm 18 zwei als Parallelogramm-Abschnitte ausgebildete Tragarme 41, 42 vorgesehen sind. Dabei kann in jedem Tragarm 41, 42 jeweils ein Gewichtsausgleich und eine Klemmvorrichtung in nicht näher gezeichneter Weise vorgesehen werden. Das dritte Kraftfahrzeugprüfgerät 40 ist besonders universell einsetzbar; bei ihm können die Kabel 23 vergleichsweise am kürzesten gehalten werden.

Die Fig. 4 zeigt einen Teil eines vierten Kraftfahrzeugprüfgerätes 50, das sich vom denjenigen nach Fig. 1 vor allem dadurch unterscheidet, daß in dem am Arm 18 aufgehängten Gerät 51 über die bisherigen Funktionen hinaus zusätzliche Bauelemente integriert sind. So weist das Gerät 51 eine Anzeigevorrichtung 52 auf, an der eine Bedienungsperson beim Prüfen des Kraftfahrzeugs 22 unmittelbar vor Ort die entsprechenden Werte ablesen kann. Ferner ist am Gerät 51 eine zusätzliche Bedieneinrichtung 53 vorgesehen, wodurch ein Kfz-Mechaniker unmittelbar in der Nähe des Motors die gewünschten Bedienfunktionen eingeben kann. Darüber hinaus ist am Gerät 51 an dessen Boden ein zusätzlicher Steckanschluß 54 angeordnet, von dem ein Schlauch 55 anstelle eines elektrischen Kabels zu einem Druckanschluß 56 geführt ist, der ebenfalls in der Aufhängevorrichtung 25 gehalten ist. Über diesen Schlauch 55 werden fluidische Signale dem Gerät 51 eingegeben, in dem ein elektrofluidischer Wandler 57 das fluidische Signal in ein geeignetes elektrisches Signal umwandelt, das zusätzlich im Gerät 51 aufbereitet und weiter im Testsystem 13 verarbeitet wird. Ferner sind an der Oberseite des Geräts 51 zusätzliche Anlagen 58 vorgesehen, die einem Kfz-Mechaniker Handhabungserleichterungen bieten, indem er Werkzeuge, Kleinteile oder seine Fernbedienung griffbereit ablegen kann.

Bei dieser Ausbildung des Geräts 51 lassen sich komplette Testfunktionen direkt in der Nähe des zu prüfenden Motors plazieren. Dies läßt sich vor allem durch die Miniaturisierung von elektronischen Bauelementen günstig durchführen. Die Bedienung und Anzeige der Meßergebnisse erfolgt in nächster Nähe, also im Griffbereich und im Blickfeld des Kfz-Mechanikers.

## Patentansprüche

1. Fahrbares Kraftfahrzeugprüfgerät mit einem mit Rollen versehenen Gestell und einem darauf angeordneten, Meß- und Prüfeinrichtungen aufweisenden Testsystem sowie mit einem an dessen Gehäuse befestigten, schwenkbaren Kabelausleger, an dessen frei auskragendem Ende mehrere, an ihren Enden Anschlüsse aufweisende Kabel gehalten sind sowie mit einer Aufhängevorrichtung zum Aufbewahren der Anschlüsse der flexiblen Kabel dadurch gekennzeichnet, daß unterhalb dem frei auskragenden Ende (20) des Kabelauslegers (15) mit Hilfe eines senkrechten Armes (19) ein Teilfunktionen übernehmendes Gerät (19, 51) so befestigt ist, so daß es im Betrieb etwa in Motorraumhöhe des zu prüfenden Fahrzeugs zu liegen kommt, daß das Gerät (19, 51) die Aufhängevorrichtung (25) für die Anschlüsse (24, 56) der Kabel (23, 55) aufweist und daß wenigstens ein Teil der anderen Enden der Kabel (23, 55) am Gerät (19, 51) mit Steckanschlüssen (26, 54) befestigt sind.

2. Kraftfahrzeugprüfgerät nach Anspruch 1, dadurch gekennzeichnet, daß im Gerät (19, 51) zumindest die Sensorelektronik für die die Anschlüsse (24) bildenden Sensoren angeordnet ist.

3. Kraftfahrzeugprüfgerät nach Anspruch 1 oder 2, dadurch gekennzeichnet, daß das Gerät (51) eine Anzeigevorrichtung (52) aufweist.

4. Kraftfahrzeugprüfgerät nach einem der Ansprüche 1 bis 3, dadurch gekennzeichnet, daß das Gerät (51) eine Bedieneinrichtung (53) für das Testsystem (13) aufweist.

5. Kraftfahrzeugprüfgerät nach einem der Ansprüche 1 bis 4, dadurch gekennzeichnet, daß das am Kabelausleger (15) befestigte, horizontal verschwenkbare Gerät (19, 51) zusätzlich vertikal verstellbar ist.

6. Kraftfahrzeugprüfgerät nach Anspruch 5, dadurch gekennzeichnet, daß für den Kabelausleger (15) und/oder das Gerät (19, 51) eine Gewichtsentlastungseinrichtung (32) vorgesehen ist.

7. Kraftfahrzeugprüfgerät nach Anspruch 5 oder 6, dadurch gekennzeichnet, daß der Kabelausleger (15) eine am Gehäuse (14) des Testsystems (13) gelagerte Schwenkachse (16) aufweist, die mittels einer Verstelleinrichtung höhenverstellbar ist.

8. Kraftfahrzeugprüfgerät nach Anspruch 5 oder 6, dadurch gekennzeichnet, daß der Kabelausleger (15) wenigstens einen die Höhenverstellung ermöglichenden, als Parallelogramm ausgebildeten Tragarm (31) aufweist.

9. Kraftfahrzeugprüfgerät nach Anspruch 8, dadurch gekennzeichnet, daß der Kabelausleger (15) zwei als Parallelogramm-Abschnitte ausgebildete Tragarme (41, 42,) aufweist.

10. Kraftfahrzeugprüfgerät nach einem der Ansprüche 1 bis 9, dadurch gekennzeichnet, daß das Gerät (51) einen elektro-fluidischen Wandler (57) aufweist und das zu diesem Wandler (57) führende Kabel als ein zur Übertragung eines fluidischen Signals geeigneter Schlauch (55) ausgebildet ist.

11. Kraftfahrzeugprüfgerät nach einem der Ansprüche 1 bis 10, dadurch gekennzeichnet, daß die Meß- und Prüfeinrichtungen des Testsystems (13) mit dem Gerät (19, 51) über störungssichere Signalübertragungsmittel verbunden sind, insbesondere durch Optokopplung oder durch Lichtleittechnik.

12. Kraftfahrzeugprüfgerät nach einem der Ansprüche 1 bis 11, dadurch gekennzeichnet, daß am Gerät (19, 51) wenigstens eine Ablage (58) angeordnet ist.

## Claims

1. Motor vehicle mobile test unit having a frame provided with rollers and a test system arranged on it which has measuring and testing devices and having a pivotable cable boom, which is fastened to its casing and on whose freely cantilevered end are held a plurality of cables which have connections at their ends and having a suspension appliance for holding the connections of the flexible cables, characterized in that a unit (19, 51) undertaking partial functions is fastened underneath the freely cantilevered end (20) of the cable boom (15) by means of a vertical arm (19) in such a way that during operation, it comes to rest at approximately the engine compartment level of the vehicle to be tested, in that the unit (19, 51) has the suspension appliance (25) for the connections (24, 56) of the cables (23, 55) and in that at least some of the other ends of the cables (23, 55) are fastened on the unit (19, 51) by means of plug-in connections (26, 54).

2. Motor vehicle test unit according to Claim 1, characterized in that at least the sensor electronics for the sensors forming the connections (24) are arranged in the unit (19, 51).

3. Motor vehicle test unit according to Claim 1 or 2, characterized in that the unit (51) has a display appliance (52).

4. Motor vehicle test unit according to one of Claims 1 to 3, characterized in that the unit (51) has an operating device (53) for the test system (13).

5. Motor vehicle test unit according to one of Claims 1 to 4, characterized in that the horizontally pivotable unit (19, 51) fastened on the cable boom (15) is additionally adjustable vertically.

6. Motor vehicle test unit according to Claim 5, characterized in that a weight balancing device (32) is provided for the cable boom (15) and/or the unit (19, 51).

7. Motor vehicle test unit according to Claim 5 or 6, characterized in that the cable boom (15) has a pivot pin (16) which is supported on the casing (14) of the test system (13) and which can be adjusted in height by means of an adjusting device.

8. Motor vehicle test unit according to Claim 5 or 6, characterized in that the cable boom (15) has at least one support arm (31) which is configured as a parallelogram and which permits the height adjustment.

9. Motor vehicle test unit according to Claim 8, characterized in that the cable boom (15) has two support arms (41, 42) configured as parallelogram sections.

10. Motor vehicle test unit according to one of Claims 1 to 9, characterized in that the unit (51) has an electro-fluidic converter (57) and the cable leading to this converter (57) is configured as a hose (55) suitable for the transmission of a fluidic signal.

11. Motor vehicle test unit according to one of Claims 1 to 10, characterized in that the measuring and testing devices of the test system (13) are connected to the unit (19, 51) by means of interference-free signal transmission means, in particular by optocoupling or by fibre optic technology.

12. Motor vehicle test unit according to one of Claims 1 to 11, characterized in that at least one place of deposit (58) is arranged on the unit (19, 51).

## Revendications

1. Appareil mobile de contrôle de véhicule automobile, comprenant un châssis monté sur roulettes et portant le système diagnostique avec ses équipements de mesure et de contrôle, une potence porte-câbles montée tournante sur le boîtier du système et portant, à l'extrémité de son bras, des câbles flexibles terminés par des raccords qui sont placés en attente sur un dispositif de suspension, caractérisé en ce qu'un appareil (19, 51) contenant des fonctions partielles est fixé par une tige verticale (19) au bras (15) sous son extrémité en porte-à-faux (20), cet appareil qui vient en service se placer sensiblement à la hauteur du compartiment moteur du véhicule à contrôler, portant le dispositif de suspension (25) des raccords (24, 56) des câbles (23, 55), tandis qu'au moins une partie des autres extrémités de ces câbles sont fixées à l'appareil (19, 51) par des raccords embrochables (26, 54).

2. Appareil de contrôle selon la revendication 1, caractérisé en ce que l'appareil (19, 51) contient au moins l'électronique associée aux détecteurs constituant les raccords (24).

3. Appareil de contrôle selon la revendication 1 ou 2, caractérisé en ce que l'appareil (51) comporte un dispositif indicateur (52).

4. Appareil de contrôle selon l'une des revendications 1 à 3, caractérisé en ce que l'appareil (51) comporte un dispositif de commande (53) du système diagnostique (13).

5. Appareil de contrôle selon l'une des revendications 1 à 4, caractérisé en ce que l'appareil (19, 51) fixé à la potence (14) et pouvant pivoter horizontalement est également réglable en hauteur.

6. Appareil de contrôle selon la revendication 5, caractérisé en ce que le bras de la potence (15) et/ou l'appareil (19, 51) sont équipés d'un dispositif d'allégement (32).

7. Appareil de contrôle selon la revendication 5 ou 6, caractérisé en ce que la potence (15) comporte un axe de pivotement (16) monté sur le boîtier (14) du système diagnostique (13) et réglable en hauteur.

8. Appareil de contrôle selon la revendication 5 ou 6, caractérisé en ce que la potence (15) a un bras porteur (31) constitué par un parallélogramme permettant le réglage en hauteur.

9. Appareil de contrôle selon la revendication 8, caractérisé en ce que la potence (15) comporte deux bras porteurs (41, 42) constitués chacun d'un parallélogramme articulé.

10. Appareil de contrôle selon l'une des revendications 1 à 9, caractérisé en ce que l'appareil (51) comporte un convertisseur électrofluidique (57) auquel est raccordé un tuyau (55) apte à transmettre un signal par l'intermédiaire d'un fluide.

11. Appareil de contrôle selon l'une des revendications 1 à 10, caractérisé en ce que les organes de contrôle et de mesure du système diagnostique (13) sont reliés à l'appareil (19, 51) par des moyens de transmission de signaux non perturbables utilisant en particulier l'optoélectronique ou des fibres optiques.

12. Appareil de contrôle selon l'une des revendications 1 à 11, caractérisé en ce que l'appareil (19, 51) comporte au moins un plateau de réception (58).
